# FASCICULE DE BREVET EUROPEEN

(11) **EP 3 443 389 B1**
(45) Date de publication et mention de la délivrance du brevet: **18.03.2020**
(21) Numéro de dépôt: 17721201.6
(22) Date de dépôt: 10.04.2017
(51) Int. Cl.: G01T 1/17

(54) **DISPOSITIF DE COMPTAGE DE PARTICULES POUR DÉTECTEUR DE RAYONNEMENT**
TEILCHENZÄHLER FÜR STRAHLUNGSDETEKTOR
PARTICLE COUNTING DEVICE FOR RADIATION DETECTION

(30) Priorité: 14.04.2016 FR 1653312
(43) Date de publication de la demande: 20.02.2019
(73) Titulaire: Commissariat à l'énergie atomique et aux énergies alternatives, 75015 Paris (FR)
(72) Inventeur: OUVRIER-BUFFET, Patrice, 74410 SAINT-JORIOZ (FR)
(74) Mandataire: Cabinet Beaumont
(86) Numéro de dépôt international: PCT/FR2017/050860
(87) Numéro de publication internationale: WO 2017/178745

(56) Documents cités:
- WO-A1-2011/039312
- WO-A2-2008/146230

## Description

### Domaine

La présente description concerne de façon générale les systèmes électroniques et, plus particulièrement, la réalisation d'un dispositif de comptage de particules pour un détecteur de rayonnement. La présente description concerne plus précisément le comptage de photons captés par un détecteur en matériau semiconducteur.

### Exposé de l'art antérieur

Un détecteur de photons est le plus souvent constitué d'une matrice de pixels, chaque pixel comportant une zone semiconductrice de photodétection associée à une électronique de comptage des photons détectés dans la zone. La zone semiconductrice de détection, par exemple à base de germanium ou de silicium, est sensible au rayonnement ionisant constitué de photons énergétiques, par exemple des rayons X ou gamma. L'énergie des photons, généralement détectables par de tels détecteurs semiconducteurs, est comprise entre 1 keV et quelques MeV.

Les détecteurs visés par la présente description ont de multiples applications. Ils se retrouvent, par exemple, dans des appareils d'imagerie médicale (radiographie, scanner, etc.), dans des dispositifs d'examen radiographique d'objets (par exemple, le contrôle de bagages dans les aéroports), dans des ondes nucléaires, etc.

Dans ces applications, le détecteur est un spectromètre comportant une source de rayonnement émettant des photons avec des niveaux d'énergie différents. Ce rayonnement traverse un élément (matériau, objet, corps, etc.) à analyser avant d'arriver sur un détecteur de photons. Le détecteur de photons exploite alors les différentes quantités de photons reçues avec différentes énergies afin de déterminer les matériaux traversés.

Les détecteurs de photons visés par la présente description exploitent un comptage du nombre de photons reçus dans différentes bandes d'énergie par les différentes zones de détection. Chaque détecteur de photons de la matrice a une constitution similaire.

Pour des raisons de sensibilité des détecteurs et afin d'éviter, entre autres, que plusieurs photons d'énergie moindre soient comptés comme un photon d'énergie supérieure, ce qui entraine une erreur d'interprétation, on est généralement conduit, dans les dispositifs de détection multiniveaux, à réduire la taille des pixels. Cependant, on se trouve alors confronté à des problèmes de partage de charges entre plusieurs pixels voisins.

Il existe un besoin d'améliorer les dispositifs détecteurs de photons basés sur un comptage du nombre de photons.

Le document WO 2008/146230 décrit un système de comptage de photons dans lequel des compteurs de photons sont incrémentés par rapport à des seuils établis. La valeur des compteurs est ensuite modifiée suite à un traitement dans une chaîne incluant un dérivateur. Le traitement effectué est un traitement correctif postérieur au comptage.

### Résumé

Un mode de réalisation pallie tout ou partie des inconvénients des dispositifs de comptage de photons.

Un mode de réalisation propose une solution particulièrement adaptée à des dispositifs de comptage multiniveaux.

Un mode de réalisation propose une solution compatible avec un traitement numérique.

Ainsi, un mode de réalisation prévoit un circuit de comptage de photons, comportant :
une borne d'entrée destinée à être connectée à un détecteur de rayonnement ionisant ;
un étage analogique de génération d'un signal impulsionnel dont chaque impulsion a une amplitude proportionnelle à l'énergie libérée par une interaction d'au moins un photon dans le détecteur ; et
un étage numérique comportant :
   au moins un premier comparateur de l'amplitude des impulsions par rapport à un premier seuil ;
   un circuit dérivateur de détermination des périodes dans lesquelles la dérivée du signal impulsionnel est d'un même signe ;
   au moins une première porte logique de type ET de combinaison des sorties du premier comparateur et du circuit dérivateur ; et
   au moins un premier compteur du nombre d'impulsions présentes en sortie de l'élément de combinaison.

Selon un mode de réalisation, le circuit dérivateur et le premier comparateur reçoivent le même signal.

Selon un mode de réalisation, l'élément de combinaison est une porte logique réalisant une fonction ET.

Selon un mode de réalisation, l'étage numérique comporte plusieurs voies en parallèle, chaque voie comportant :
un comparateur de l'amplitude des impulsions par rapport à un seuil ;
un élément de combinaison des sorties du comparateur de la voie concernée et du circuit dérivateur ; et
un compteur du nombre d'impulsions présentes en sortie de l'élément de combinaison de la voie concernée.

Selon un mode de réalisation, les seuils des différentes voies sont différents et sont croissants d'une voie à la suivante.

Selon un mode de réalisation, le nombre fourni par le compteur d'une voie est diminué du nombre fourni par le compteur de la voie ayant un seuil de valeur immédiatement supérieure.

Selon un mode de réalisation, le circuit dérivateur est commun à toutes les voies.

Un mode de réalisation prévoit un système d'examen par rayonnement ionisant comportant au moins un circuit tel que ci-dessus.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une représentation schématique et simplifiée d'un système d'examen par rayonnement ionisant ;
la figure 2 représente, sous forme de blocs, un exemple de circuit de comptage de photons ;
la figure 3 représente, sous forme de blocs, un exemple de circuit usuel de comptage multiniveau ;
les figures 4A, 4B, 4C et 4D illustrent, par des chronogrammes, un exemple de fonctionnement du circuit de la figure 2 ;
les figures 5A, 5B, 5C et 5D illustrent, par des chronogrammes, un exemple de fonctionnement du circuit de la figure 3 en supposant une réalisation à trois voies ;
la figure 6 représente, sous forme de blocs, un mode de réalisation d'un circuit de comptage multiniveau ; et
les figures 7A, 7B, 7C, 7D, 7E, 7F, 7G et 7H illustrent, par des chronogrammes, un exemple de fonctionnement du circuit de la figure 6.

### Description détaillée

Par souci de clarté, seuls les éléments qui sont utiles à la compréhension des modes de réalisation décrits ont été représentés et seront détaillés. En particulier, la réalisation d'un système utilisant un ou plusieurs circuits de comptage de photons n'a pas été détaillée, les modes de réalisation décrits étant compatibles avec les utilisations usuelles de tels systèmes. De plus, la constitution et la réalisation des circuits en amont du circuit de comptage, ainsi que la réalisation des détecteurs en matériau semiconducteur n'ont pas non plus été détaillées, les modes de réalisation décrits étant compatibles avec les réalisations usuelles de tels détecteurs et circuits. Il est à noter que, sur les figures, les éléments structurels et/ou fonctionnels communs aux différents modes de réalisation peuvent présenter les mêmes références et peuvent disposer de propriétés structurelles, dimensionnelles et matérielles identiques. Sauf précision contraire, les expressions "approximativement", "sensiblement" et "de l'ordre de" signifient à 10 % près, de préférence à 5 % près.

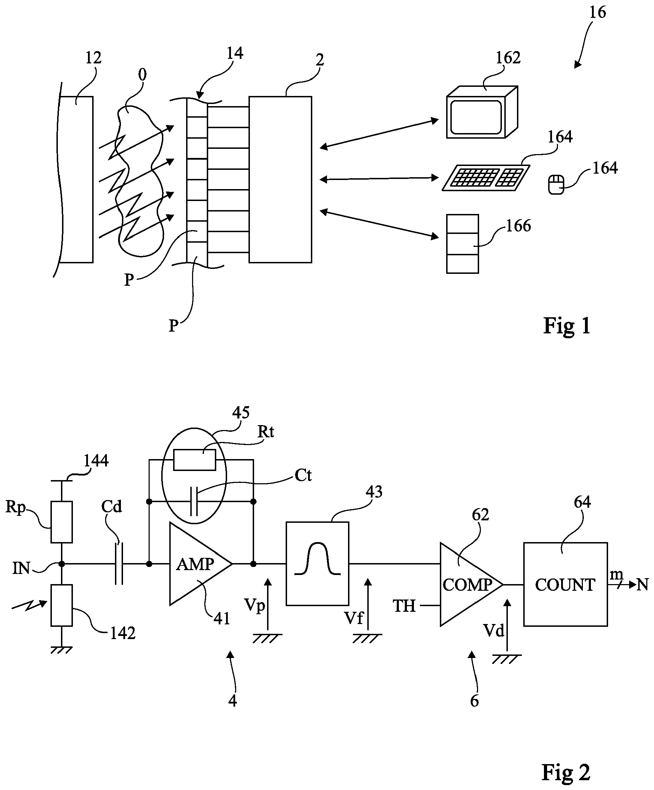

La figure 1 est une représentation schématique et simplifiée d'un système d'examen par rayonnement ionisant.

Un tel système comporte généralement une source 12 d'émission d'un rayonnement ionisant, par exemple de rayons X ou gamma. Un détecteur 14 de photons, constitué de plusieurs pixels P de détection en matériau semiconducteur, arrangés par exemple en matrice, est placé en regard de la source 12. Un objet O, élément ou corps, à analyser est placé entre la source 12 et le détecteur 14 pour que le rayonnement émis par la source 12 traverse (ou non, ou plus ou moins, selon les matériaux rencontrés) l'objet O avant d'atteindre le détecteur 14. Le détecteur 14 est relié à un dispositif 2 électronique de traitement des informations fournies par le détecteur. En pratique, chaque pixel P du détecteur 14 est associé à un circuit de comptage. Le dispositif 2 comporte donc autant de circuits de comptage que le capteur 14 comporte de pixels P. Les résultats du comptage sont exploités, le plus souvent, par un équipement informatique 16 comportant des dispositifs d'interface utilisateur (par exemple, un ou plusieurs écrans de contrôle 162, un ou plusieurs dispositifs d'entrée-sortie 164 de type clavier, souris, etc.), des éléments de stockage 166, par exemple de type base de données, système de stockage distant, etc. Les éléments d'un tel système d'examen, hormis les circuits de comptage, ne sont pas modifiés par la mise en oeuvre des modes de réalisation décrits.

La figure 2 représente, sous forme de blocs, un exemple de circuit de comptage de photons d'un dispositif de traitement (par exemple du dispositif 2 de la figure 1).

L'élément de détection (le pixel) est un photodétecteur 142 en matériau semiconducteur, par exemple de type phototransistor, connecté en série avec une résistance de polarisation Rp, entre une borne 144 d'application d'un potentiel (positif ou négatif) et la masse. La conduction du photodétecteur 142 et par conséquent le niveau du signal présent au point milieu IN de l'association en série de la résistance Rp et du photodétecteur 142 sont conditionnés par le nombre et l'énergie des photons reçus. Le noeud IN constitue la borne d'entrée du circuit de comptage de photons. Ce circuit comporte un étage 4 de traitement analogique ou de mise en forme et un étage 6 de traitement numérique ou de comptage proprement dit.

Le signal présent sur la borne IN est traité par un amplificateur 41 (AMP) de l'étage 4 dont une borne d'entrée est reliée à la borne IN par un condensateur de découplage Cd et dont une borne de sortie est reliée à une borne d'entrée d'un circuit 43 de mise en forme de type filtre passe-bande ou filtre impulsionnel. Une cellule 45 résistive et capacitive, constituée par exemple d'une résistance Rt en parallèle avec un condensateur Ct, relie la sortie de l'amplificateur 41 à son entrée et fixe la constante de temps d'intégration. Le filtre 43 de l'étage 4 transforme le signal Vp, fourni par l'amplificateur 41, en signal impulsionnel Vf permettant d'isoler temporellement les photons reçus, l'amplitude des impulsions étant fonction du niveau d'énergie des photons reçus.

Le signal Vf de sortie du filtre 43 est envoyé sur une première entrée d'un comparateur 62 (COMP) de l'étage 6, dont une deuxième entrée reçoit un seuil de comparaison TH. Le comparateur 62 réalise une conversion analogique-numérique. La sortie du comparateur 62 fournit un signal numérique représentatif du nombre de photons reçus avec une énergie supérieure au seuil TH. Le signal Vd de sortie du comparateur 62 est traité par un compteur 64 dont la sortie fournit, par exemple, un nombre N sur plusieurs bits en parallèle. La constitution du circuit de la figure 2 est usuelle.

En pratique, dans la plupart des applications, on a besoin d'un dispositif de comptage multiniveau, c'est-à-dire capable de compter le nombre de photons reçus dans différentes bandes d'énergie. Pour cela, le circuit de comptage associé à chaque élément photodétecteur 142 comporte plusieurs compteurs (au moins deux) associés à plusieurs comparateurs ayant des seuils de comparaison différents les uns des autres.

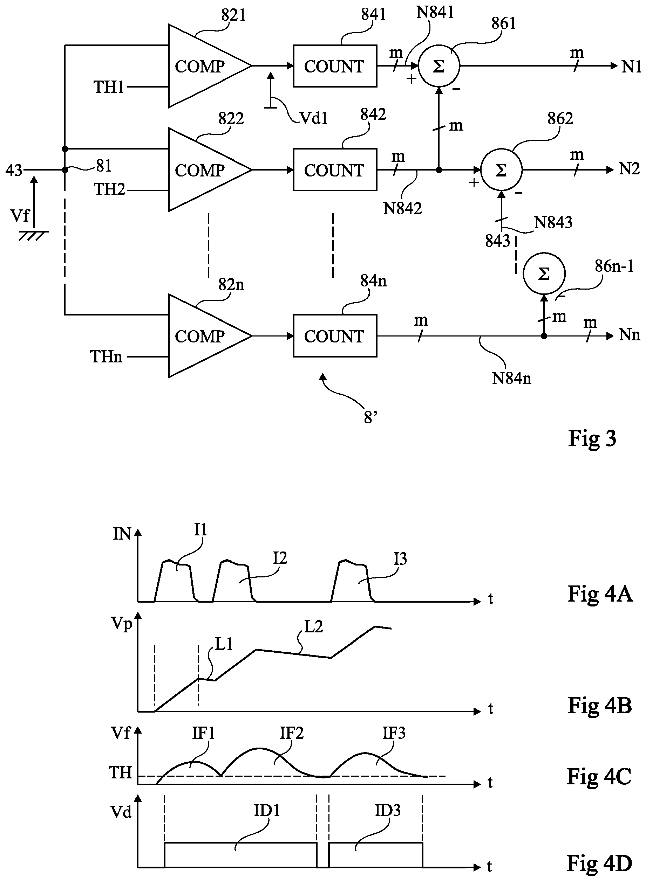

La figure 3 représente, sous forme de blocs, un exemple de circuit de comptage multiniveau. En figure 3, seul l'étage numérique 8' du circuit de comptage a été représenté, l'étage analogique étant identique à celui représenté en figure 2. En d'autres termes, une borne 81 d'entrée du circuit 8' reçoit le signal Vf de sortie du filtre 43 de l'étage 4 de la figure 2.

L'étage 8' comporte un nombre n de voies i (i allant de 1 à n) correspondant au nombre de plages de niveaux que l'on souhaite distinguer dans le signal reçu. Chaque voie i comporte un comparateur 82i (COMP - 821, 822, ..., 82n en figure 3) dont une première entrée est reliée à la borne 81 et dont une deuxième entrée reçoit un seuil THi (TH1, TH2, ..., THn en figure 3). La sortie de chaque comparateur 82i est reliée à l'entrée d'un compteur 84i (COUNT - 841, 842, ..., 84n en figure 3). La sortie N841, N842, N843, ..., N84n de chaque compteur 84i fournit un nombre sur m bits représentant le nombre de photons ayant une énergie supérieure au seuil THi de la voie concernée.

Les seuils THi sont différents les uns des autres et sont, par exemple, de valeurs décroissantes du seuil TH1 au seuil THn. L'écart entre un seuil de rang i et le seuil suivant de rang i+1 représente la plage détectée par la voie de rang i. Pour obtenir le nombre de photons ayant une énergie comprise dans la plage comprise entre les seuils THi et THi+1, on soustrait le nombre fourni par le compteur 84i+1 à celui fourni par le compteur 84i. Pour cela, la sortie d'un compteur 84i de rang i est reliée à une première entrée + d'un soustracteur 86i (861, 862, ..., 86n-1 en figure 3) dont une deuxième entrée - (de soustraction) reçoit le nombre fourni par le compteur 84i+1 de rang i+1 (842, 843, ..., 84n en figure 3). Chaque soustracteur 86i est par exemple un sommateur (∑) monté en soustracteur. Le compteur 84n de rang n fournit directement le nombre de photons dans la plage de plus haute énergie (supérieure à THn).

Les figures 4A, 4B, 4C et 4D illustrent, par des chronogrammes, un exemple de fonctionnement du circuit de la figure 2 en cas de photons temporellement proches. Cela peut également s'apparenter au fonctionnement d'une voie de l'étage de la figure 3 dans une situation similaire. La figure 4A représente un exemple de signal présent en entrée IN (figure 2) du circuit de comptage. La figure 4B représente un exemple d'allure correspondante du signal Vp en sortie de l'amplificateur 41 (figure 2). La figure 4C représente un exemple d'allure correspondante du signal Vf en sortie du filtre impulsionnel 43 (figure 2) et en entrée de l'étage numérique (6, figure 2 ou 8', figure 3). La figure 4D représente un exemple d'allure correspondante du signal Vd en sortie du comparateur 62 (figure 2) ou du signal Vdi d'un comparateur 82i ayant le même seuil.

Dans tous les chronogrammes des figures (4, 5 et 7), on prend arbitrairement pour exemple des signaux positifs par rapport à la masse.

Selon cet exemple, on suppose la présence, dans le signal IN, de trois impulsions I1, I2 et I3 représentant, successivement, trois photons ayant une énergie similaire (amplitude des impulsions approximativement identiques). Deux premières impulsions I1 et I2 sont proches l'une de l'autre par rapport à l'écart temporel séparant l'impulsion I2 de la troisième impulsion I3. En sortie de l'amplificateur 41 (figure 4B), l'intégration réalisée se traduit par une croissance du signal Vp avec deux paliers L1 et L2 représentatifs des intervalles entre chaque impulsion. Une fois le signal Vd filtré, le signal Vf résultant comporte trois impulsions analogiques IF1, IF2 et IF3, les deux dernières étant plus espacées l'une de l'autre temporellement, elles se traduisent par un amortissement plus important du signal entre les deuxième et troisième impulsions. En supposant que le seuil TH (ou THi) se situe entre les niveaux inférieurs d'amortissement entre les impulsions IF1 et IF2 et entre les impulsions IF1 et IF3, on assiste à un phénomène d'accumulation ou d'empilement des deux premières impulsions. En effet, le signal Vf n'a pas le temps de redescendre en dessous du seuil entre les impulsions IF1 et IF2. Le signal Vd comporte alors une impulsion ID1 de durée relativement longue et une impulsion ID2 de durée courte par rapport à celle de l'impulsion ID1. Il en découle que le compteur (64, figure 2 ou 84i, figure 3) va compter une impulsion ID1 alors qu'il aurait dû en compter deux.

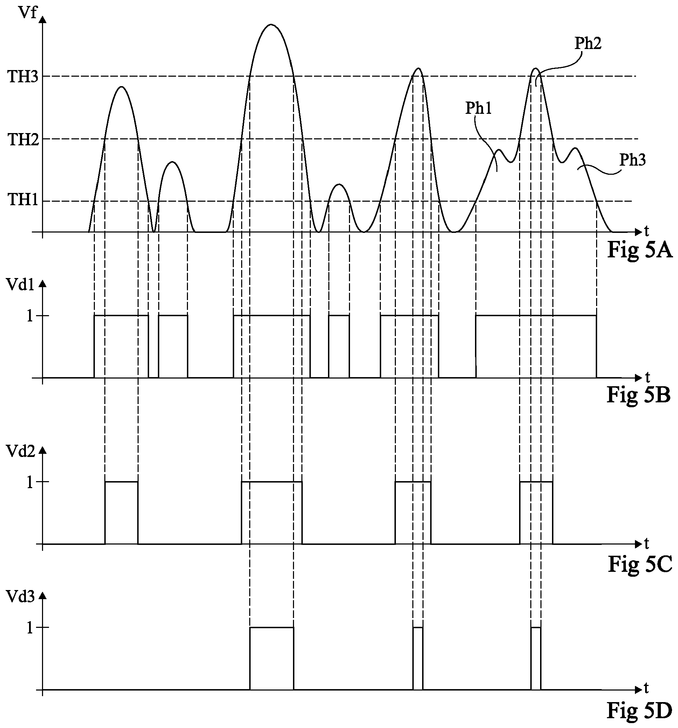

Les figures 5A, 5B, 5C et 5D illustrent, par des chronogrammes, un exemple de fonctionnement de l'étage 8' de la figure 3 en supposant une réalisation à trois voies (n=3). La figure 5A représente un exemple d'allure du signal Vf. Les figures 5B, 5C et 5D représentent des exemples correspondant des allures des sorties Vd1, Vd2 et Vd3 des comparateurs 821, 822 et 823 des trois voies.

Pendant toutes les périodes où l'amplitude du signal Vf dépasse les seuils respectifs TH1, TH2 et TH3, les signaux Vd1, Vd2 et Vd3 sont respectivement à l'état haut (état logique 1) et sont à l'état bas (état logique 0) le reste du temps. Le choix de l'état logique en fonction de l'état haut ou bas est arbitraire et conventionnel. On suppose que le signal Vf traduit, successivement, un photon de niveau d'énergie intermédiaire (entre les seuils TH2 et TH3), un photon de niveau bas (entre les seuils TH1 et TH2), un photon de niveau haut (supérieur au seuil TH3), un photon de niveau bas, un photon de niveau haut, et enfin un photon Ph2 de niveau haut encadré par deux photons Ph1 et Ph3 de niveau bas mais rapprochés temporellement et subissant le phénomène d'empilement illustré par les figures 4A à 4D. On suppose que les photons Ph1, Ph2 et Ph3 sont suffisamment rapprochés temporellement pour que le signal Vf n'ait pas le temps de redescendre en dessous du seuil TH1 entre ces photons Ph1 et Ph2, et entre les photons Ph2 et Ph3. Les signaux Vd1, Vd2 et Vd3 comportent donc respectivement 6, 4 et 3 impulsions qui sont comptées par les compteurs 841, 842 et 843. Il en découle que les nombres N3, N2 et N1 respectivement fournis par le compteur 843 et par les sommateurs 862 et 861, pour la durée représentée aux figures 5A à 5D, sont 3, 1 (4-3) et 2 (6-4). Il y a donc, à cause de l'empilement des photons Ph1, Ph2 et Ph3, une erreur de comptage (le compte correct étant 3, 1, 4).

Dans l'exemple des figures 5A à 5D, le nombre de photons de niveau supérieur est correct. Toutefois, il peut également se produire que le rapprochement temporel et que les différences de niveau entre deux photons successifs soient tels que le circuit voit un photon de niveau supérieur alors qu'il n'y en a pas et qu'il s'agit de deux photons de niveau intermédiaire.

Le problème d'empilement est particulièrement présent pour des dispositifs de comptage devant fonctionner dans des larges gammes d'énergie. De plus, plus les plages d'énergie sont étroites, plus le risque est important.

Réduire la taille des pixels, donc des détecteurs, peut réduire le phénomène. Toutefois, si les pixels deviennent trop petits, on assiste à un phénomène de partage de charges entre des pixels voisins, ce qui provoque d'autres erreurs de détection.

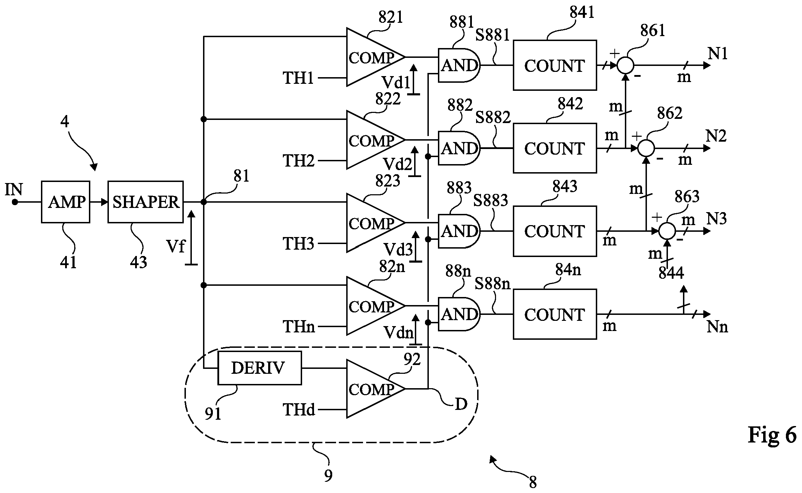

La figure 6 représente, sous forme de blocs, un mode de réalisation d'un circuit de comptage multiniveau.

Ce circuit de comptage comporte un étage analogique 4 du type de celui illustré en relation avec la figure 2 (amplificateur 41 (AMP) et circuit 43 de mise en forme (SHAPER) de type filtre passe-bande ou filtre impulsionnel). Ce circuit de comptage comporte également un étage numérique 8 à n voies qui comporte, entre autres les éléments du circuit de la figure 3 (comparateurs 82i de 1 à n, compteurs 84i de 1 à n, et sommateurs 86i de 1 à n-1). L'étage 8 comporte également un dérivateur 9 (DERIV) dont le rôle est de fournir un signal numérique D représentatif des périodes du signal Vf pendant lequel ce dernier croît. L'étage 8 comporte en outre n portes logiques 88i (881, 882, 883, ..., 88n en figure 6) de type ET (AND) intercalées entre les sorties respectives des comparateurs 82i et les entrées des compteurs 84i associés et combinant les sorties respectives des comparateurs 82i avec le signal D. Une première entrée de chaque porte logique 88i est reliée à la sortie du comparateur 82i de même rang. Les deuxièmes entrées des portes 88i sont reliées en sortie du dérivateur 9 et reçoivent le signal D. Les sorties respectives S88i (S881, S882, S883, ..., S88n en figure 6) des portes 88i sont reliées aux entrées des compteurs 84i de rang correspondant.

Le dérivateur 9 peut être réalisé de différentes façons. Par exemple, il comporte un circuit 91 détectant le signe de la pente du signal Vf de façon analogique et fournissant un signal numérisé par un comparateur 92 (COMP). Une première entrée du comparateur 92 est reliée à la sortie du circuit 91 et une deuxième entrée du comparateur 92 reçoit un seuil THd. La sortie du comparateur fournit le signal D. Le seuil THd peut théoriquement être nul mais est, en pratique, de préférence choisi pour être supérieur au niveau considéré comme représentatif du bruit de mesure. Par ailleurs, le seuil THd est inférieur au seuil TH1 le plus bas de l'étage 8.

D'autres types de dérivateurs peuvent être utilisés, par exemple, un dérivateur numérique, un dérivateur basé sur des capacités commutées, etc.

En variante, le dérivateur 9 peut fournir un signal D représentatif des périodes où le signal Vf décroît.

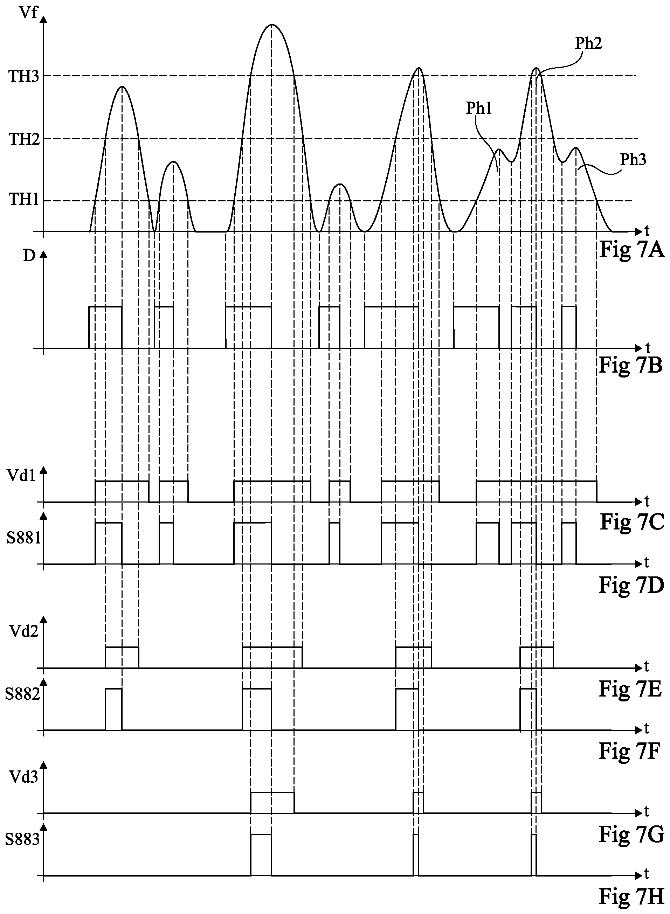

Les figures 7A, 7B, 7C, 7D, 7E, 7F, 7G et 7H illustrent, par des chronogrammes, un exemple de fonctionnement de l'étage 8 de la figure 6 en supposant une réalisation à trois voies (n=3). La figure 7A représente un exemple d'allure du signal Vf. La figure 7B représente un exemple correspondant d'allure du signal D de sortie du dérivateur 9. Pour simplifier, on considère un seuil THd nul. Les figures 7C, 7E et 7G représentent des exemples correspondants des allures des sorties Vd1, Vd2 et Vd3 des comparateurs 821, 822 et 823 des trois voies. Les figures 7D, 7F et 7H représentent des exemples correspondants des allures des sorties S881, S882 et S883 des portes logiques 881, 882 et 883 des trois voies, soit les signaux d'entrée des compteurs 841, 842 et 843.

De façon similaire à la réalisation de la figure 3, pendant toutes les périodes où l'amplitude du signal Vf dépasse les seuils respectifs TH1, TH2 et TH3, les signaux Vd1, Vd2 et Vd3 sont respectivement à l'état haut (état logique 1) et sont à l'état bas (état logique 0) le reste du temps. Ici encore, le choix de l'état logique en fonction de l'état haut ou bas est arbitraire et conventionnel. L'exemple de la figure 7A reprend le même exemple qu'en figure 5A. On suppose donc que le signal Vf traduit, successivement, un photon de niveau d'énergie intermédiaire (entre les seuils TH2 et TH3), un photon de niveau bas (entre les seuils TH1 et TH2), un photon de niveau haut (supérieur au seuil TH3), un photon de niveau bas, un photon de niveau haut, et enfin un photon Ph2 de niveau haut encadré par deux photons Ph1 et Ph3 de niveau bas mais rapprochés temporellement et subissant un phénomène d'empilement. Les photons Ph1, Ph2 et Ph3 sont suffisamment rapprochés temporellement pour que le signal Vf n'ait pas le temps de redescendre en dessous du seuil TH1 entre ces photons Ph1 et Ph2, et entre les photons Ph2 et Ph3. Comme aux figures 5B, 5C et 5D, les signaux Vd1, Vd2 et Vd3 comportent donc respectivement six, quatre et trois impulsions.

Le signal D, indicateur des périodes de dérivée positive du signal Vf, comporte huit impulsions représentant les périodes croissantes du signal Vf. En particulier, au niveau des photons Ph1, Ph2 et Ph3, le signal D comporte trois impulsions. Les signaux S881, S882 et S883, qui résultent des combinaisons du signal D avec les signaux Vd1, Vd2 et Vd3, comportent une impulsion pour chaque période avec en outre, au niveau des photons Ph1, Ph2 et Ph3, une division de l'impulsion unique de la figure 7C en trois impulsions sur la figure 7D. Il en résulte que les nombres N3, N2 et N1 respectivement fournis par le compteur 843 et par les sommateurs 862 et 861 sont, pour la durée représentée aux figures 7A à 7H, 3, 1 (4-3) et 4 (6-4).

Les autres phénomènes d'empilement, comme par exemple, deux photons suffisamment proches pour être cumulés sont également corrigés par le circuit décrit pourvu que la dérivée du signal change de sens entre les deux photons.

Un avantage du mode de réalisation de la figure 6 est qu'il résout les problèmes d'empilement que ce soit dans un système mono ou multiniveau.

Un autre avantage est que ce mode de réalisation est compatible avec un compromis sur la dimension des pixels pour améliorer la résolution du dispositif.

Un autre avantage des modes de réalisation décrits est que, grâce à la prise en compte (combinaison) du résultat du dérivateur avant incrémentation des compteurs, le comptage s'effectue en temps réel et ne requiert pas de post traitement.

A titre d'exemple particulier de réalisation, des pixels ayant une taille comprise entre 400µm^{∗}400µm et 700µm^{∗}700µm constituent une taille de pixel appropriée.

Divers modes de réalisation ont été décrits. Diverses variantes et modifications apparaîtront à l'homme de l'art. En particulier, le choix des seuils des différents comparateurs et du dérivateur dépend de l'application et, entre autres, de la gamme d'énergie du détecteur. En outre, la mise en oeuvre pratique des modes de réalisation qui ont été décrits est à la portée de l'homme de métier à partir des indications fonctionnelles données ci-dessus.

## Revendications

1. Circuit de comptage de photons, comportant :
une borne d'entrée (IN) destinée à être connectée à un détecteur de rayonnement ionisant (142) ;
un étage analogique (4) de génération d'un signal impulsionnel dont chaque impulsion a une amplitude proportionnelle à l'énergie libérée par une interaction d'au moins un photon dans le détecteur ; et
un étage numérique (8) comportant :
au moins un premier comparateur (82i) de l'amplitude des impulsions par rapport à un premier seuil (THi) ;
un circuit dérivateur (9) de détermination des périodes dans lesquelles la dérivée du signal impulsionnel est d'un même signe ;
au moins une première porte logique, de type ET (88i), de combinaison des sorties du premier comparateur et du circuit dérivateur ; et
au moins un premier compteur (84i) du nombre d'impulsions présentes en sortie de l'élément de combinaison.

2. Circuit selon la revendication 1, dans lequel le circuit dérivateur (9) et le premier comparateur (82i) reçoivent le même signal.

3. Circuit selon la revendication 1 ou 2, dans lequel l'étage numérique (8) comporte plusieurs voies en parallèle, chaque voie comportant :
un comparateur (82i) de l'amplitude des impulsions par rapport à un seuil (THi) ;
un élément (88i) de combinaison des sorties du comparateur de la voie concernée et du circuit dérivateur (9) ; et
un compteur (84i) du nombre d'impulsions présentes en sortie de l'élément de combinaison de la voie concernée.

4. Circuit selon la revendication 3, dans lequel les seuils (THi) des différentes voies (i) sont différents et sont croissants d'une voie à la suivante.

5. Circuit selon la revendication 4, dans lequel le nombre fourni par le compteur (84i) d'une voie est diminué du nombre fourni par le compteur (84i+1) de la voie ayant un seuil (THi+1) de valeur immédiatement supérieure.

6. Circuit selon l'une quelconque des revendications 3 à 5, dans lequel le circuit dérivateur est commun à toutes les voies.

7. Système d'examen par rayonnement ionisant comportant au moins un circuit selon l'une quelconque des revendications 1 à 6.

## Patentansprüche

1. Photonenzählschaltung, die Folgendes aufweist:
einen Eingangsanschluss (IN), der vorgesehen ist, um mit einem Detektor (142) für ionisierende Strahlung verbunden zu werden;
eine analoge Stufe (4) zur Erzeugung eines Impulssignals, wobei jeder der Impulse des Impulssignals eine Amplitude proportional zu der Energie hat, die durch eine Interaktion von mindestens einem Photon in dem Detektor freigegeben wird; und
eine digitale Stufe (8), welche Folgendes aufweist:
zumindest einen ersten Komparator bzw. ein erstes Vergleichselement (82i) für die Amplitude der Impulse bezüglich einer ersten Schwelle (THi);
einen Differenzierer (9) zum Bestimmen der Perioden, wann die Ableitung des Impulssignals ein gleiches Vorzeichen hat;
zumindest ein erstes UND-Logikgatter (88i) zum Kombinieren der Ausgangsgrößen des ersten Vergleichselementes und des Differenzierers; und
zumindest einen ersten Zähler (84i) für die Anzahl der Impulse, die am Ausgang des Kombinationselementes vorhanden sind.

2. Schaltung nach Anspruch 1, wobei der Differenzierer (9) und das erste Vergleichselement (82i) das gleiche Signal aufnehmen.

3. Schaltung nach Anspruch 1 oder 2, wobei die digitale Stufe (8) eine Vielzahl von parallelen Pfaden aufweist, wobei jeder Pfad Folgendes aufweist:
einen Komparator bzw. ein Vergleichselement (82i) für die Amplitude der Impulse bezüglich einer Schwelle (THi);
ein Element (88i) zum Kombinieren der Ausgangsgrößen des Kombinationselementes des betreffenden Pfades und des Differenzierers (9); und
einen Zähler (84i) für die Anzahl der Impulse, die am Ausgang des Kombinationselementes des betroffenen Pfades vorhanden sind.

4. Schaltung nach Anspruch 3, wobei die Schwellen (THi) von unterschiedlichen Pfaden (i) unterschiedlich sind und von einem Pfad zum nächsten zunehmen.

5. Schaltung nach Anspruch 4, wobei die Anzahl, die durch den Zähler (84i) eines Pfades geliefert wird, um die Anzahl verringert wird, die durch den Zähler (84i +1) des Pfades mit einer Schwelle (THi + 1) mit einem direkt größeren bzw. folgenden Wert geliefert wird.

6. Schaltung nach einem der Ansprüche 3 bis 5, wobei der Differenzierer für alle Pfade gemeinsam ist.

7. System zur Untersuchung durch ionisierende Strahlung, welches zumindest eine Schaltung nach einem der Ansprüche 1 bis 6 aufweist.

## Claims

1. A photon counting circuit, comprising:
an input terminal (IN) intended to be connected to an ionizing radiation detector (142);
an analog pulse signal generation stage (4), each of the pulses of the pulse signal having an amplitude proportional to the energy released by an interaction of at least one photon in the detector; and
a digital stage (8) comprising:
at least one first comparator (82i) of the amplitude of the pulses with respect to a first threshold (THi);
a differentiating circuit (9) for determining the periods when the derivative of the pulse signal has a same sign;
at least one first AND-type logic gate (88i) for combining the outputs of the first comparator and of the differentiating circuit; and
at least one first counter (84i) of the number of pulses present at the output of the combination element.

2. The circuit of claim 1, wherein the differentiating circuit (9) and the first comparator (82i) receive the same signal.

3. The circuit of claim 1 or 2, wherein the digital stage (8) comprises a plurality of paths in parallel, each path comprising:
a comparator (82i) of the amplitude of the pulses with respect to a threshold (THi);
an element (88i) for combining the outputs of the comparator of the concerned path and of the differentiating circuit (9); and
a counter (84i) of the number of pulses present at the output of the combination element of the concerned path.

4. The circuit of claim 3, wherein the thresholds (THi) of the different paths (i) are different and are increasing from one path to the next one.

5. The circuit of claim 4, wherein the number supplied by the counter (84i) of a path is decreased by the number supplied by the counter (84i+1) of the path having a threshold (THi+1) having an immediately greater value.

6. The circuit of any of claims 3 to 5, wherein the differentiating circuit is common to all paths.

7. A system of examination by ionizing radiation comprising at least one circuit of any of claims 1 to 6.
